# FASCICULE DE BREVET EUROPEEN

(11) **EP 2 035 847 B1**
(45) Date de publication et mention de la délivrance du brevet: **26.05.2010**
(21) Numéro de dépôt: 07765334.3
(22) Date de dépôt: 06.06.2007
(51) Int. Cl.: G01R 29/10, G01S 17/74

(54) **SYSTEME DE RECONNAISSANCE OPTIQUE DE LA POSITION ET DU MOUVEMENT D'UN OBJET SUR UN DISPOSITIF DE POSITIONNEMENT**
OPTISCHES ERKENNUNGSSYSTEM ZUM ERKENNEN DER POSITION UND BEWEGUNG EINES OBJEKTS AUF EINEM POSITIONSBESTIMMUNGSGERÄT
OPTICAL RECOGNITION SYSTEM FOR RECOGNISING THE POSITION AND THE MOVEMENT OF AN OBJECT ON A POSITIONING DEVICE

(30) Priorité: 23.06.2006 EP 06115988
(43) Date de publication de la demande: 18.03.2009
(73) Titulaire: The Swatch Group Research and Development Ltd., 2074 Marin (CH)
(72) Inventeur: GRANGE, Matthieu, 1022 Chavannes (CH); CASAGRANDE, Arnaud, 2014 Bôle (CH)
(74) Mandataire: Ravenel, Thierry Gérard Louis
(86) Numéro de dépôt international: PCT/EP2007/055609
(87) Numéro de publication internationale: WO 2007/147738

(56) Documents cités:
- WO-A-97/25239
- GB-A- 2 234 877
- US-A- 4 764 668
- US-A- 4 901 073
- US-A- 6 087 941
- US-A1- 2005 176 375

## Description

L'invention concerne un système de reconnaissance optique de la position et/ou du mouvement d'un objet sur un dispositif de positionnement. Le dispositif de positionnement comprend des moyens pour entraîner l'objet en rotation et/ou selon un trajet curviligne ou rectiligne. Le système comprend encore des moyens de détection optique de la position ou orientation de l'objet, et une station de traitement des données fournies par les moyens de détection.

Pour la reconnaissance d'une position ou orientation d'un objet, certains systèmes de reconnaissance optique sont susceptibles de déterminer principalement le contour de l'objet sur son support, par exemple sur un dispositif de positionnement. Pour ce faire, des moyens de détection optique, tels qu'une caméra, permettent de prendre au moins une image du contour de l'objet afin de fournir des signaux de données relatives notamment au contour de l'objet à une station de traitement de signaux de données. Une comparaison du contour détecté de l'objet avec une forme de référence mémorisée, dont la position dans l'espace est connue, est réalisée dans la station de traitement. Sur la base de cette comparaison, le système de traitement peut être en mesure de déterminer une position ou orientation de l'objet sur le dispositif de positionnement.

Un inconvénient de tels systèmes de reconnaissance optique réside essentiellement dans le fait que la position ou orientation de l'objet déterminée par son contour n'est pas précise. De plus de tels systèmes de reconnaissance ne peuvent pas être utilisés dans le cas où l'objet est de forme sphérique, car la détermination du contour de l'objet est identique dans toute position ou orientation. Ces systèmes de reconnaissance optique ne peuvent donc pas être utilisés par exemple dans des systèmes de mesure du diagramme de rayonnement d'une antenne d'émission, qui est placée dans un objet sphérique creux entraîné en rotation sur un dispositif de positionnement.

Le document FR 2 590 681 décrit un système de localisation d'un objet muni de mires passives disposé sur un engin spatial. Le système de localisation comprend notamment un circuit capteur de proximité, qui comprend un dispositif d'imagerie numérique et une source d'émission de lumière en direction des mires sur l'objet. Un balayage de l'objet par faisceau de lumière est opéré depuis la source lumineuse pour permettre au dispositif d'imagerie de repérer les différentes mires de positionnement. Ces mires sont différentes l'une de l'autre et forment des codes à barres parallèles de forme rectangulaire ou trapézoïdale. Ces codes à barres sont répartis par exemple en nombre égal à 4 éloignés les uns des autres sur une surface plane de l'objet. Un inconvénient d'un tel système de localisation est qu'il ne permet pas de fournir une mesure précise de la position de l'objet par rapport au circuit capteur. De plus, il n'est en mesure de détecter une orientation angulaire limitée de l'objet sur un dispositif de positionnement.

L'invention a donc pour objet de fournir un système de reconnaissance optique de la position et/ou du mouvement d'un objet sur un dispositif de positionnement de manière précise, simple et rapide dans toutes les orientations angulaires de l'objet afin de pallier les inconvénients de l'état de la technique cité ci-dessus.

A cet effet, l'invention concerne un système de reconnaissance optique de la position et/ou du mouvement d'un objet sur un dispositif de positionnement qui comprend les caractéristiques définies dans la revendication indépendante 1.

Des formes particulières d'exécution du système de reconnaissance sont définies dans les revendications dépendantes 2 à 14.

Un avantage du système de reconnaissance optique selon l'invention réside dans le fait que des figures ou références différentes sont réparties uniformément sur la surface extérieure de l'objet de préférence de forme sphérique. Ces figures sont avantageusement des codes à barres circulaires codés sur 4 bits, ainsi qu'un bit supplémentaire de délimitation extérieure par exemple de couleur noire sur la surface extérieure de l'objet par exemple de couleur claire (blanche). Ceci permet aux moyens de détection, tels qu'une caméra numérique, associés à la station de traitement des données dans lequel un algorithme de reconnaissance de position est mémorisé, de reconnaître chaque position au cours du temps de l'objet.

Avantageusement, le dispositif de positionnement sur lequel l'objet de forme sphérique est placé et maintenu par gravité sur trois points d'appui, comprend un organe d'entraînement qui est constitué par une roue en contact de la surface extérieure de l'objet, et un support de cette roue d'entraînement. L'axe de rotation de la roue est monté à l'extrémité du support, qui est susceptible de tourner selon un autre axe passant par le point de contact de la roue sur la surface extérieure de l'objet sphérique et le centre de l'objet sphérique. Le support monté rotatif sur une structure mécanique du dispositif de positionnement, et la roue d'entraînement peuvent être entraînés en rotation par l'intermédiaire de moyens à air comprimé.

Pour permettre une bonne prise d'image par la caméra numérique, il est avantageusement prévu un dispositif d'éclairage isotrope (uniforme) de la surface visible de l'objet de forme sphérique. Un ensemble de fibres optiques guide de la lumière fournie par une source de lumière distante pour illuminer l'objet. L'ensemble de fibres optiques est séparé en plusieurs sous-ensembles à proximité de l'objet. Les extrémités des fibres optiques d'un sous-ensemble, par exemple au nombre de 6 par sous-ensemble, sont fixées dans un plot plastique fixé sur une structure d'éclairage. De préférence, 6 plots plastiques maintenant chacun 6 extrémités de fibres optiques sont fixés à distance égale l'un de l'autre sur la structure d'éclairage. Cette structure d'éclairage est configurée en forme d'anneau et placée juste devant l'objet du côté de la caméra numérique sans obstruer la vision de l'objet par la caméra numérique.

Les buts, avantages et caractéristiques du système de reconnaissance optique de la position et/ou du mouvement d'un objet sur un dispositif de positionnement apparaîtront mieux dans la description suivante en regard des dessins sur lesquels :
- la figure 1 représente de manière simplifiée les différents éléments, qui composent le système de reconnaissance optique selon l'invention faisant partie d'un système de mesure du diagramme de rayonnement d'une antenne d'émission,
- la figure 2 représente une partie du dispositif d'éclairage pour illuminer l'objet défini comme un élément sphérique posé sur le dispositif de positionnement du système de reconnaissance optique selon l'invention,
- les figures 3a et 3b représentent une vue en coupe partielle dans le sens de la longueur et une vue de dessus d'une rotule à bille du dispositif de positionnement du système de reconnaissance optique selon l'invention,
- la figure 4 représente une illustration des coordonnées sphériques utilisées pour la détermination de la position de l'objet comme un élément sphérique sur le dispositif de positionnement du système de reconnaissance optique selon l'invention,
- la figure 5 montre l'emplacement des figures ou références sur la surface extérieure de l'objet sphérique pour déterminer la position de l'objet sur le dispositif de positionnement du système de reconnaissance optique selon l'invention, et
- la figure 6 représente une figure sous la forme d'un code à barres circulaires à placer sur la surface extérieure de l'objet sphérique pour déterminer sa position ou orientation du système de reconnaissance optique selon l'invention.

Dans la description suivante, tous les éléments du système de reconnaissance optique de la position et/ou du mouvement d'un objet sur un dispositif de positionnement qui sont bien connus de l'homme du métier dans ce domaine technique ne sont relatés que de manière simplifiée. Il est à noter que ce système de reconnaissance optique peut être utilisé sans limitation dans diverses applications dans lesquelles il est nécessaire de connaître la position précise d'un objet posé sur un support ou dispositif de positionnement. L'objet peut être également une antenne de réception pour capter des signaux radiofréquences qui doit être précisément orientée sur le dispositif de positionnement. L'objet peut également être un projecteur, un haut-parleur, un indicateur, ou tout autre objet ou instrument électronique. Cependant dans la description suivante, il ne sera fait référence qu'à un système de reconnaissance optique faisant partie d'un système de mesure du rayonnement d'une antenne d'émission d'un dispositif électronique.

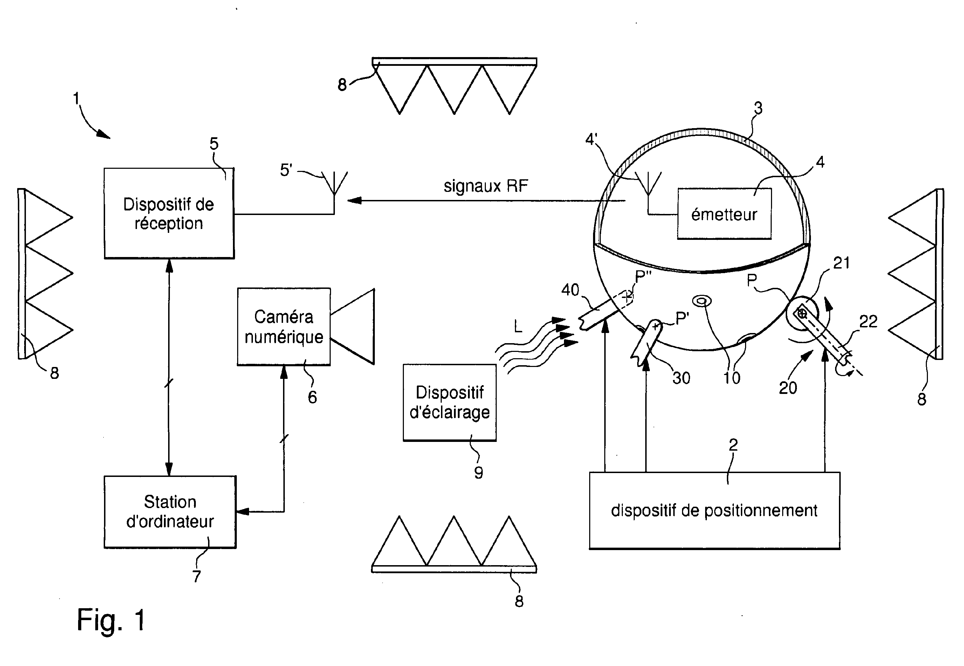

La figure 1 illustre de manière schématique tous les éléments du système de reconnaissance optique d'un objet 3 sur un dispositif de positionnement 2 faisant partie d'un système de mesure 1 du diagramme de rayonnement d'une antenne d'émission 4' d'un dispositif électronique émetteur 4. Pour l'essentiel, le système de mesure 1 comprend tout d'abord un dispositif de positionnement 2 sur lequel est placé et maintenu sur trois points d'appui P, P', P" des membres 20, 30, 40 par gravité un objet configuré sous la forme d'un élément sphérique 3 comme support par exemple pour le dispositif électronique. Ledit dispositif électronique à antenne d'émission 4' à mesurer est maintenu à l'intérieur de cet élément sphérique creux 3, qui comprend deux parties, qui s'emboîtent par tout moyen connu l'une sur l'autre pour enfermer le dispositif électronique. L'antenne d'émission 4' est positionnée de préférence voisine du centre de cet élément sphérique ou sphère creuse.

Le système de mesure comprend encore un dispositif de réception 5 muni d'au moins une antenne de réception 5' pour capter le champ électromagnétique de l'antenne d'émission 4' (signaux RF), des moyens de détection optique 6 de la position ou orientation de l'élément sphérique en mouvement sur le dispositif de positionnement 2. L'élément sphérique comprend un certain nombre de figures ou références 10 réparties sur la surface extérieure de l'élément, comme expliqué ci-après, qui servent à la détermination de position de l'élément sphérique. Les signaux relatifs au champ électromagnétique captés par l'antenne de réception et des signaux de position fournis par les moyens de détection sont transmis automatiquement ou sur requête à une station de traitement des données, qui est de préférence une station d'ordinateur 7. Le dispositif de réception 5 et les moyens de détection optique, qui sont formés par une caméra numérique 6, peuvent être alimentés en énergie électrique indépendamment de la station d'ordinateur ou par l'intermédiaire de ladite station d'ordinateur.

La caméra numérique est de préférence une caméra du type MOS en noir et blanc à 768 x 1024 pixels, qui est placée à une distance voisine d'un ou plusieurs mètres de l'objet. Une carte d'acquisition peut être prévue entre la caméra numérique et la station d'ordinateur pour permettre d'adapter les signaux de prise d'image à transférer à la station d'ordinateur. Cette carte pour caméra numérique, notamment la carte référencée PCl6229 est dotée d'une connexion "firewire" grâce à un module NI-IMAQ for IEEE 1394 cameras et permet de générer ou d'acquérir des signaux numériques ou analogiques.

Le dispositif de positionnement 2 n'est représenté par simplification sur la figure 1 que par les membres 20, 30, 40 supportant l'élément sphérique 3 pour les opérations de mesure du champ électromagnétique produit par l'antenne d'émission du système de mesure. Ce dispositif de positionnement 2 comprend donc un organe d'entraînement 20 en contact avec la surface extérieure de l'élément sphérique. Cet organe d'entraînement est configuré de telle manière à faire tourner aléatoirement dans toutes les directions l'élément sphérique 3 sur le dispositif de positionnement.

Cet organe d'entraînement 20 est constitué d'une roue 21 qui vient en contact de la surface extérieure de l'élément sphérique pour l'entraîner en rotation. La roue peut comprendre un élément sous forme d'anneau en caoutchouc disposé dans une rainure circulaire d'une poulie pour permettre d'entraîner l'élément sphérique sans glisser. L'axe de rotation de cette roue 21 est monté à l'extrémité d'un support 22 ou tige. Ce support 22 est susceptible de tourner selon un autre axe passant par le point de contact P de la roue sur la surface extérieure de l'élément sphérique et le centre dudit élément. Ceci permet ainsi d'imposer une rotation aléatoire de l'élément sphérique par l'intermédiaire de la roue dans toutes les directions. Il peut être estimé un temps de 10 minutes, pour que l'élément sphérique parcoure toutes les positions. Pendant ce laps de temps, il peut être compté environ 6'000 mesures du champ électromagnétique émis par l'antenne d'émission.

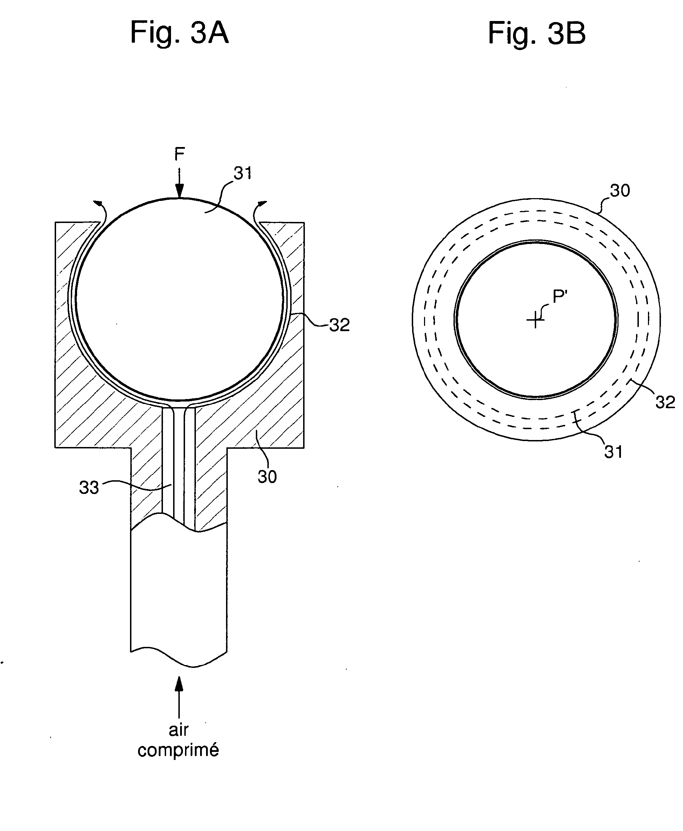

Le dispositif de positionnement 2 comprend encore deux rotules à bille 30 et 40 expliquées ci-après en référence aux figures 3a et 3b. Chaque bille des rotules est arrangée pour venir en contact de la surface extérieure de l'élément sphérique 3. Ainsi, les contacts de la roue 21 et de chaque bille des deux rotules 30, 40 constituent les trois points d'appui P, P', P" sur lesquels l'élément sphérique repose. Ces trois points d'appui peuvent être espacés régulièrement pour former les extrémités d'un triangle, tel qu'un triangle équilatéral disposé de préférence horizontalement. Bien entendu, le centre de gravité de l'élément sphérique 3 doit se trouver dans toute position à l'intérieur de ce triangle équilatéral pour être maintenu sur le dispositif de positionnement. L'espace entre chaque point d'appui doit être de préférence supérieur au rayon de l'élément sphérique et inférieur à 1.5 fois le rayon dudit élément sphérique.

En lieu et place de trois roues d'entraînement d'un dispositif de l'art antérieur, qui constituaient les trois points d'appui de l'élément sphérique, une seule roue d'entraînement 21 ne dérape plus en contact de la surface extérieure de l'élément sphérique. Ceci permet à l'élément sphérique 3 de décrire aléatoirement avec beaucoup d'homogénéité l'ensemble de l'espace des positions. Cette roue d'entraînement est de préférence entraînée par un moteur ou turbine à air comprimé non représenté, qui est logé dans le support à proximité de ladite roue 21 ou sur l'axe de rotation de la roue. Au moins un conduit ou tuyau flexible à air comprimé est réalisé dans le support pour faire circuler l'air comprimé provenant d'un réservoir à air comprimé vers le moteur.

Un autre moteur ou turbine à air comprimé peut être utilisé pour entraîner en rotation le support 22 de la roue d'entraînement 21. Dans ce cas, un ensemble de poulies et de courroies d'entraînement, non représentés, entre ledit moteur et le support 22 peut permettre d'imposer la rotation souhaitée au support pour faire tourner l'axe de rotation de la roue d'entraînement. Avec cette seule roue d'entraînement, les sautillements de l'élément sphérique sur les trois points d'appui ont disparu. Le seul déplacement du centre de l'élément sphérique observable réside de son mal rond naturel et du jeu des roulements (poulies) de l'ordre du millimètre. Ceci est susceptible d'impliquer une erreur de calcul d'angle de l'ordre 0.05 degrés du système de mesure, ce qui est négligeable.

Les figures 3a et 3b représentent une des rotules à bille 30 du dispositif de positionnement pour servir d'un des points d'appui de l'élément sphérique. Cette rotule 30, qui peut être de forme extérieure généralement cylindrique, comprend un logement 32 pour la bille en matière synthétique. Ce logement est dimensionné de telle manière que la bille est libre de rotation à l'intérieur de ce logement. Ce logement peut être de forme sphérique ou de forme cylindrique. De préférence, la rotule est réalisée en un matériau non conducteur et à faible coefficient de frottement, tel qu'en Téflon, pour la bille libre de rotation.

Une portion de la bille 31 débouche hors du logement 32 par une ouverture supérieure de la rotule 30 pour venir en contact de la surface extérieure de l'élément sphérique. Une force F représentant une partie du poids de l'élément sphérique est appliquée au point d'appui P' sur la bille. Cette ouverture est de diamètre inférieur au diamètre de la bille pour maintenir la bille à l'intérieur du logement 32.

Pour un logement de forme sphérique, la rotule comprend deux parties s'emboîtant l'une sur l'autre dans le sens de la longueur pour enfermer la bille dans le logement. Dans le cas d'un logement de forme cylindrique par contre, l'ouverture supérieure est réalisée dans un couvercle, non représenté, fermant partiellement le logement. La rotule est configurée également sous la forme d'une buse pour amener de l'air comprimé par un conduit 33 de la rotule jusque dans le logement 32 de la bille. De cette façon, la bille est maintenue dans son logement sur un coussin d'air.

Dans le cas où l'élément sphérique 3 est posé uniquement sur deux buses d'air comprimé, dont le débit est réglé, alors que le troisième point d'appui est la roue d'entraînement, il est facile de faire flotter et tourner l'élément sphérique. Toutefois, l'élément sphérique est dans certains cas animé d'un mouvement oscillant. Il se rapproche d'une buse, ce qui augmente la pression d'air et l'éjecte quelque peu. Dans le cas où la pression locale, donc la force de soutien, diminue, l'élément sphérique retombe sur la buse qui l'éjecte à nouveau. De ce fait avec ces buses d'air comprimé, cela nécessite un réglage de la pression d'air en fonction du poids de la sphère, ce qui est résolu par les rotules à bille selon l'invention. Un filet d'air comprimé sort de l'ouverture du logement 32 autour de la bille 31, dont la pression est fonction du poids de l'élément sphérique, ce qui évite le problème de simples buses à air comprimé. L'élément sphérique peut librement être entraîné en rotation sans à-coup dans toutes les directions.

Pour résoudre un éventuel problème lié au déséquilibrage de l'élément sphérique sur les trois points d'appui, il peut être prévu d'augmenter le poids de l'élément sphérique en introduisant une rotule supplémentaire à son sommet ou rotule de pression. Cette rotule peut être réalisée à l'aide d'une bille coulissant dans un tuyau d'air comprimé et permettant de générer à l'image d'un ressort une force constante sur l'élément sphérique. La résultante de cette pression normale au contact de la roue motrice d'entraînement permet une meilleure adhérence de ladite roue.

La majeure partie des composants du système de mesure avec la caméra numérique est placée à l'intérieur d'une chambre anéchoïque illustrée par les éléments référencés 8 sur la figure 1. Ceci permet d'éviter toute réflexion du champ électromagnétique produit par l'antenne d'émission 4' contre des obstacles susceptibles de nuire à la mesure du rayonnement de l'antenne d'émission. De plus, aucune partie du dispositif de positionnement 2 à proximité de l'antenne d'émission, c'est-à-dire à l'intérieur de ladite chambre, ne doit être composée de matériau métallique pour ne pas perturber la mesure du champ électromagnétique produit par l'antenne d'émission 4'. Les moyens d'entraînement du dispositif de positionnement 2, qui sont en plastique ou en matériau non conducteur, fonctionnent par l'intermédiaire d'air comprimé. Ces moyens d'entraînement peuvent être des moteurs ou turbines à air comprimé reliés par des tuyaux à robinets à un réservoir d'air comprimé. Ces moteurs non métalliques pour l'entraînement de la roue et du support de roue selon deux axes peuvent être placés donc à proximité de l'antenne d'émission.

De manière à déterminer précisément la position ou orientation de l'élément sphérique 3, donc de l'antenne d'émission 4' à mesurer qu'il comprend, il est prévu de placer des figures ou références spécifiques 10 sur la surface extérieure de l'élément sphérique 3. Ces figures ou références sont constituées par des codes à barres circulaires, chaque code à barres circulaires définissant une position précise de l'élément sphérique sur le dispositif de positionnement. Chaque code à barres circulaires 10 peut être imprimé ou collé sur la surface extérieure de la sphère ou réalisé par tout autre moyen.

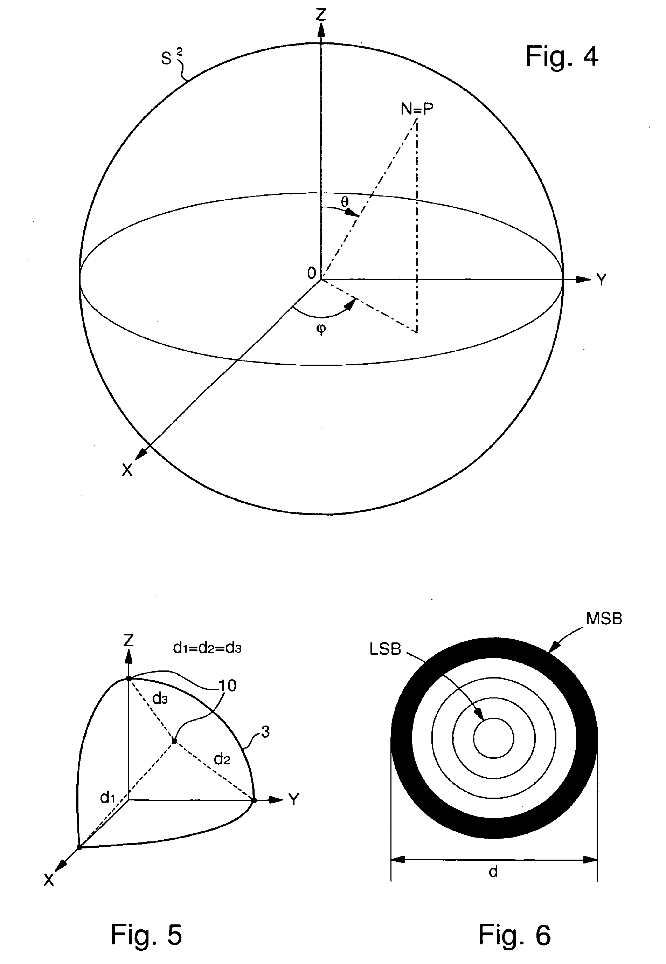

Il est prévu par exemple 14 codes à barres circulaires différents de diamètre identique, qui sont répartis uniformément sur la surface extérieure de l'élément sphérique comme expliqué ci-après en référence aux figures 5 et 6. Chaque code à barres circulaires étant codé sur 4 bits, ainsi qu'un bit de délimitation extérieure de couleur différente de la couleur de la surface extérieure de l'élément sphérique. De préférence, la surface extérieure de l'élément sphérique est de couleur claire, par exemple de couleur blanche, alors qu'au moins le bit supplémentaire de délimitation extérieure est de couleur foncée, par exemple de couleur noire.

Pour améliorer la prise d'images par la caméra numérique, qui doit être en mesure de prendre par exemple 15 images par seconde, le système de reconnaissance optique comprend encore un dispositif d'éclairage isotrope 9. Ce dispositif d'éclairage 9 est configuré de telle manière à fournir des faisceaux de lumière L en direction d'au moins une moitié de la surface extérieure de l'élément sphérique 3 du côté de la caméra numérique 6.

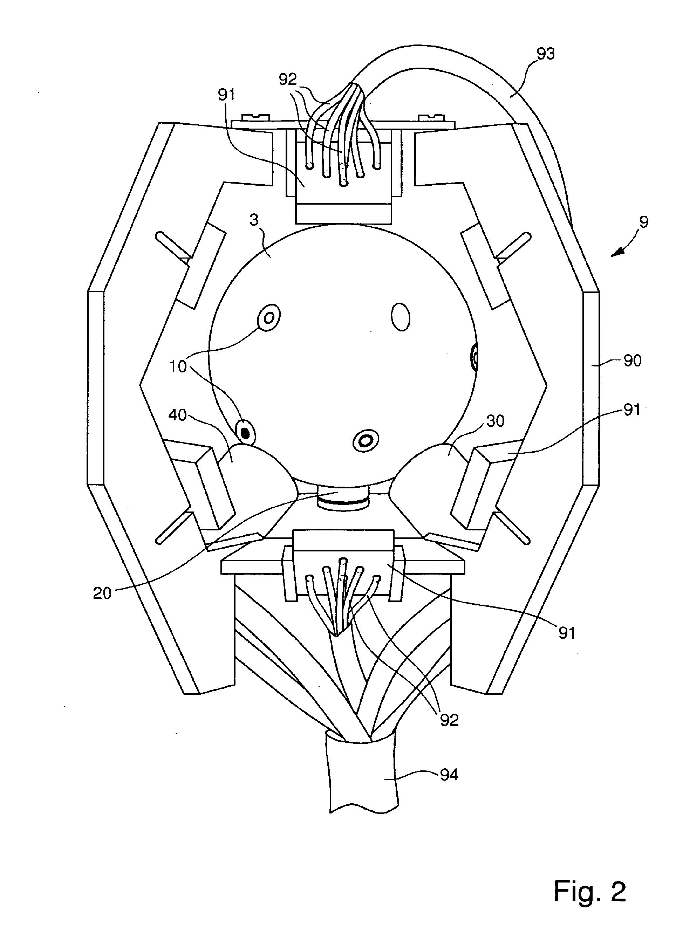

Le dispositif d'éclairage 9 de l'élément sphérique ou sphère creuse 3, qui est munie des différents codes à barres circulaires, et qui est posée sur les trois points d'appui des membres 20, 30, 40 du dispositif de positionnement, est maintenant expliqué en référence à la figure 2.

Il a été démontré que pour une reconnaissance optique de position, le système de reconnaissance optique dans un système de mesure possède une grande sensibilité à l'homogénéité de l'éclairage. Auparavant, il était utilisé un éclairage par des sources de lumière du type LED disposées entre des cônes d'absorption de la chambre anéchoïque. Toutefois, en utilisant des LED de 1 W, il a été remarqué un manque de puissance pour un bon éclairage. De plus, l'angle d'ouverture des LED est de l'ordre de 110°, ce qui nécessite l'utilisation de lentilles de focalisation devant les LED. En plus de cela, leur fixation et leur alimentation électrique pose un problème dans la chambre anéchoïque de par une connexion par fil métallique jusqu'à chaque LED, ce qui peut nuire à la mesure du rayonnement de l'antenne d'émission.

Pour le dispositif d'éclairage selon l'invention, il est utilisé un ensemble de fibres optiques 92, dont une extrémité de chaque fibre est disposée à proximité d'une source de lumière (150 W) non illustrée pour recevoir de la lumière. Cette source de lumière est placée par exemple en dehors de la chambre anéchoïque non illustrée. Cette source de lumière peut être du type de celles utilisées pour des éclairages coaxiaux de microscopes. L'ensemble de fibres optiques est regroupé dans une gaine 94 en matériau plastique pour être dirigé dans la chambre anéchoïque jusqu'à une structure d'éclairage 90 en matière plastique.

Les fibres optiques 92 utilisées sont de préférence des fibres synthétiques dont l'extrémité du côté de la source de lumière est distante par exemple de 3.5 cm de cette source de lumière pour éviter que les fibres brûlent. De par leur souplesse, de telles fibres synthétiques peuvent être aisément manipulées. Leur diamètre peut être de l'ordre de 1 mm.

L'ensemble de fibres optiques regroupe 36 fibres optiques suffisamment longues (4 m) protégées par la gaine extérieure en matière plastique 94. L'ensemble de fibres optiques est encore réparti en plusieurs sous-ensembles de fibres optiques protégés par une autre gaine 93 en matière plastique à l'intérieur de la gaine extérieure 94. De préférence, 6 sous-ensembles de 6 fibres optiques protégés chacun par une autre gaine 93.

Les extrémités des fibres optiques de chaque sous-ensemble sont fixées dans un plot carré en plastique de 3.5 cm de côté et 1 cm d'épaisseur. Les extrémités des fibres optiques sont disposées à égale distance l'une de l'autre dans chaque plot sous la forme de triangles équilatéraux de 1.5 cm de côté. 6 plots plastiques 91 sont régulièrement disposés sur la périphérie de la structure d'éclairage 90 en forme d'anneau. Les extrémités des fibres optiques fixées dans les plots plastiques de chaque sous-ensemble sont orientées de manière à diriger des faisceaux de lumière en direction du centre de l'élément sphérique. De cette manière, l'éclairage de l'élément sphérique est rendu homogène grâce à l'ensemble de fibres optiques et leur agencement à proximité de l'élément sphérique sans l'emploi de matériau métallique.

La structure d'éclairage 90 en forme d'anneau est disposée entre la caméra numérique et l'élément sphérique 3, mais à proximité de l'élément sphérique. Elle peut être reliée mécaniquement au dispositif de positionnement. La dimension de cette structure d'éclairage est légèrement supérieure au diamètre de l'élément sphérique, qui peut être de l'ordre de 12 cm. La caméra numérique, qui peut être distante d'un ou deux mètres de l'élément sphérique, doit pouvoir observer tout l'élément sphérique à travers la structure d'éclairage 90.

En référence aux figures 4 à 6 suivantes, il est décrit la manière d'opérer du système de reconnaissance optique selon l'invention dans un système de mesure du diagramme de rayonnement d'une antenne d'émission. Il est tout d'abord à noter que pour effectuer toutes les opérations de mesure, l'antenne d'émission est toujours active de manière à générer un champ électromagnétique à fréquence, qui peut être de l'ordre du GHz. Le dispositif électronique à antenne d'émission comprend donc une propre source d'alimentation électrique, telle qu'une batterie ou un accumulateur rechargeable étant donné qu'il est enfermé dans l'élément sphérique. Avec ce système de mesure, il peut être prévu de mesurer l'antenne d'émission d'un téléphone portable (GSM) par exemple, ou tout autre appareil susceptible d'être enfermé dans l'élément sphérique.

Pour les mesures de position de l'élément sphérique avec les différents codes à barres circulaires qu'il comprend sur sa surface extérieure, les types de mesure sont basés sur les angles d'Euler θ, Φ, ψ, qui définissent l'élévation, l'azimut et la polarisation des plans de rotation. Dans des applications mécaniques, il est préférable d'utiliser les angles d'Euler pour déterminer la position d'un solide, tel que l'élément sphérique.

Un point P situé dans un espace tridimensionnel est exprimé généralement par trois coordonnées P(x,y,z). Ces coordonnées dépendent du type de coordonnées choisi (ou référentiel). Le référentiel cartésien comporte 3 vecteurs orthonormés **x, y, z**. En fonction du type d'application, ce référentiel utilisé change pour faciliter les calculs ou la visualisation.

La position d'un objet ou d'une antenne dans l'espace est caractérisée par 6 valeurs. Les 3 premières valeurs ne sont autres que les coordonnées de son centre de gravité. Les 3 autres valeurs sont les 3 angles d'Euler θ, ϕ, ψ (élévation, azimut, polarisation des plans de rotation) où uniquement deux angles sont indiqués sur la figure 4.

Le dispositif de positionnement est capable de placer l'élément sphérique qui peut par exemple contenir l'antenne d'émission à mesurer dans n'importe quelle position ou orientation, soit dans la totalité de l'espace des trois angles d'Euler (élévation θ, azimut ϕ et polarisation ψ).

Pour le calcul de la rotation dans l'espace tridimensionnel, il doit tout d'abord être précisé que la caméra numérique produit une déformation sphérique de l'image observée, notamment de l'élément sphérique ou sphère creuse sur le dispositif de positionnement. Pour une distance supérieure à 1 m entre la caméra et l'élément sphérique, l'erreur est inférieure à 0.2 %.

En négligeant la déformation sphérique développée ci-dessus, il devient facilement possible de calculer la 3^{ème} coordonnée (y, z étant mesurés, x est déterminé par l'équation x = (r² - y² - z²)^{1/2}). La rotation selon les trois angles d'Euler est une transformation dite de changement de base. La résolution mathématique de cette transformation nécessite trois équations à savoir une équation par vecteur de référence. Cependant, la rotation est une transformation isométrique qui a pour propriété de conserver les angles. Dans le cas de l'élément sphérique de l'invention, la mesure de deux vecteurs transformés suffit à déterminer complètement le changement de base, car la troisième inconnue est contenue dans la propriété d'isométrie précitée. Une manière extrêmement simple et efficace de résoudre le système est de construire un troisième vecteur par produit vectoriel des deux premiers et de l'inclure dans un système de résolution matricielle.

On remarque que la matrice inverse associée à chaque couple de vecteurs peut être facilement pré-calculée et stockée en mémoire dans la station d'ordinateur avant la phase de mesure afin de diminuer la charge processeur et d'augmenter la puissance disponible pour la reconnaissance de formes ou des codes à barres circulaires. La matrice R ainsi calculée contient les valeurs déjà transformées par les fonctions trigonométriques traditionnelles.

Lors de la mesure, il est indiqué le nombre de points parcourus sur l'élément sphérique. Une information objective sur la progression des mesures est ainsi obtenue. Cette analyse se base sur la matrice de rotation. Une fois calculée, on dispose des trois angles d'Euler. En considérant θ et ϕ, et en se basant sur la représentation de la figure 4 des coordonnées sphériques, cela revient à regarder si le point P parcourt tous les points de la sphère S². Ceci équivaut à observer si (θ, ϕ) parcourent tous les points du rectangle R = [0, π] x [-π, π] où θ est la longitude de P et ϕ est la latitude de P. Les pôles Nord et Sud de S² sont des points singuliers pour les coordonnées sphériques. Il faut par conséquent prendre quelques précautions pour calculer θ et ϕ.

Concernant la reconnaissance de la position ou orientation de l'élément sphérique sur le dispositif de positionnement, il est utilisé comme indiqué précédemment une caméra numérique du type MOS en noir et blanc à 768 x 1024 pixels. Cette caméra prend 15 images/s et fournit un signal correspondant à l'exposition à la station d'ordinateur qui comprend mémorisé un logiciel de reconnaissance rapide et précis. La caméra étant en noir et blanc, il est donc possible de travailler sur les formes des figures, qui sont de préférence des codes à barres circulaires 10.

Les figures choisies (codes à barres circulaires) ont des dimensions qui ne dépassent pas 12 mm, ce qui représente 1/10 du diamètre de l'élément sphérique. Lorsque l'élément sphérique remplit l'image prise par la caméra, il y a 768 pixels sur 12 cm, soit 76.8 pixels par figure (12 mm), ce qui suffit. Etant donné la forme de l'élément sphérique, il est préférablement utilisé des codes à barres circulaires pour garnir la surface extérieure de l'élément sphérique. Si la convexité de l'élément sphérique est négligée, la projection sur un plan tangent transforme les cercles en ellipses. Le centre d'un cercle se transforme en centre de l'ellipse dont la position définit exactement celle du cercle donc de la figure en code à barres circulaires.

Il est à noter que la caméra numérique en collaboration avec la station d'ordinateur sont susceptibles de détecter un mouvement curviligne ou de translation également de l'élément sphérique par contrôle de la variation de position et de l'espace entre deux codes à barres visibles par la caméra. Une vitesse de rotation ou de translation peut également être déterminée à l'aide des diverses figures placées sur l'élément sphérique.

Afin de voir correctement un nombre de codes à barres circulaires supérieur à deux sur l'image prise par la caméra, il est réparti 14 codes à barres circulaires sur l'élément sphérique de la manière suivante, 2 pour chaque pôle, 4 sur l'équateur, 4 pour chaque hémisphère comme montré partiellement à la figure 5. Chaque figure 10 située sur les hémisphères est équidistante au pôle et à deux figures sur l'équateur.

Il est donc utilisé 4 bits pour coder 14 figures (codes à barres circulaires), ainsi qu'un bit de délimitation extérieure toujours noir, qui définit le bord de la figure comme montré à la figure 6. Le centre de chaque code à barres circulaires définit le bit de poids faible (LSB), alors que le bit extérieur définit le bit de poids fort (MSB). Chaque bit à l'état 1 est de couleur noire, alors que chaque bit à l'état 0 est de couleur claire, notamment de couleur blanche. Avec des motifs de 12 mm de diamètre, il y a environ 7.68 pixels par barre de codage.

Ci-dessous, il est représenté un tableau de la position des figures sur la surface extérieure de l'élément sphérique avec le code en hexadécimal et les coordonnées sphériques de la position (en cm) :

| Position | Code en hexadécimal | Position en coordonnées cartésiennes |
|---|---|---|
| Pôle Nord | 1 0 0 1 1 | (0, 0, 6) |
| Pôle Sud | 1 0 1 1 1 | (0, 0, -6) |
| Equateur | 1 0 0 0 0 | (6, 0, 0) |
| | 1 1 1 0 0 | (0, 6, 0) |
| | 1 0 0 1 0 | (-6, 0, 0) |
| | 1 1 0 0 0 | (0, -6, 0) |
| Hémis. Nord | 1 0 1 0 0 | (3.46, 3.46, 3.46) |
| | 1 1 0 1 1 | (-3.46, 3.46, 3.46) |
| | 1 1 1 1 0 | (-3.46, -3.46, 3.46) |
| | 1 0 1 1 0 | (3.46, -3.46, 3.46) |
| Hémis. Sud | 1 0 0 0 1 | (3.46, 3.46, -3.46) |
| | 1 1 1 0 1 | (-3.46, 3.46, -3.46) |
| | 1 0 1 0 1 | (-3.46, -3.46, -3.46) |
| | 1 1 0 0 1 | (3.46, -3.46, -3.46) |

Pour le calcul de la rotation dans la station d'ordinateur, la matrice de rotation définit la rotation de l'élément sphérique par rapport à une position initiale sur le dispositif de positionnement. Cependant, dans le cas de l'établissement du diagramme de rayonnement pour le système de mesure, la rotation habituellement décrite est celle de l'antenne de réception donc celle de la caméra numérique par rapport à l'élément sphérique contenant l'antenne émettrice mesurée. Il s'agit donc de la rotation inverse (celle du mouvement relatif), notée R ⁻¹. Comme R est une transformation isométrique, R ⁻¹ est directement égale à la transposée de R notée R ^{T}. Il reste donc à reconstruire les valeurs d'angle θ, ϕ, ψ. Cette reconstruction est assurée par une procédure appelant les fonctions trigonométriques inverses dans un ordre bien précis afin de lever les indéterminations possibles.

Pour les opérations de traitement de l'image captée par la caméra numérique 6 présentée à la figure 1 dans la station d'ordinateur 7, une phase de calibration est tout d'abord effectuée pour détecter le centre de l'élément sphérique 3, ainsi que la mesure de son rayon. Par la suite, une reconnaissance de deux figures 10 (codes à barres circulaires) de l'image et le calcul de leurs positions sont effectués. Puis une estimation des erreurs de calculs introduites est effectuée.

Pour une opération de calibration du système de reconnaissance optique, il est effectué un calcul du rayon et du centre du cercle passant par le contour de l'élément sphérique 3. Elle détermine une référence et permet de diminuer la surface d'image à traiter. Seule une zone carrée de 0.95·rayon de côté, centré sur l'élément sphérique est conservée. Ensuite, l'image est numérisée. Le seuil optimal est déterminé par une méthode statistique.

Pour le traitement des données par un logiciel de reconnaissance mémorisé dans la station d'ordinateur, une boucle de programmation calcule la position de l'élément sphérique filmée. A chaque itération, l'image est analysée pour déterminer les deux figures visibles les plus proches du centre et leur position en pixels. Les angles d'Euler sont ensuite calculés puis stockés dans un tableau. Finalement une sauvegarde de toutes les mesures effectuées est opérée.

L'algorithme de détection de positions des figures (logiciel de reconnaissance) nécessite un référentiel précis, afin d'éviter une erreur systématique sur les positions calculées. Il a donc été développé deux algorithmes de détection automatique, qui sont une méthode par seuillage et une méthode par intercorrélation.

La méthode par seuillage se base sur la détection de contour par seuillage. Un flanc montant est repéré sur des segments placés en arc de cercle sur l'hémisphère supérieur de l'élément sphérique. Une fois que les points sont trouvés, un algorithme des moindres carrés interpole l'équation du cercle correspondant. En utilisant cet algorithme, il est remarqué que l'ombre se trouvant sur le bord de l'élément sphérique dû à l'inhomogénéité de l'éclairage perturbe la détection de contour. Un algorithme plus robuste est ainsi indispensable.

La méthode par intercorrélation utilise la corrélation de deux images afin de trouver les coordonnées du cercle délimitant le contour de l'élément sphérique. La première image est celle prise par la caméra numérique 6. La deuxième image représente un disque blanc dont le rayon est connu centré sur le fond noir. S'il est calculé la fonction d'intercorrélation, son maximum permet de déterminer le centre de l'élément sphérique. Pour trouver le rayon, une itération du calcul avec un cercle de référence à rayon variable est effectuée.

Pour une image de 200 x 200 pixels, le temps de calcul est de l'ordre de la seconde. Il est donc très long de le faire sur une image de 768 x 1024 pixels. Par conséquent, seules certaines parties de l'image sont exploitées. Sachant qu'il faut 3 points pour déterminer un cercle, 3 zones sont prises dans l'image.

Sur la base d'une fonction donnant le maximum de la somme des fonctions d'intercorrélation bidimensionnelles des 3 zones, il est possible de détecter l'indice de la colonne et de la ligne du maximum et de calculer ainsi la position du centre de l'élément sphérique. Le calcul est ensuite itéré avec des images dont le rayon varie. Pour ce faire, il est utilisé une méthode géométrique. Il est itéré 4 fois sur un rayon variant de 280 à 380 par pas de 25. Les deux rayons sont repérés avec lesquels la fonction d'intercorrélation est maximum pour réitérer dans l'intervalle 5 fois par pas de 5. Une dernière itération avec des pas de 1 détermine le rayon. Cette méthode évite d'itérer sur tous les rayons.

Pour effectuer correctement le produit d'intercorrélation de deux images, il faut annuler leurs composantes continues. La moyenne des éléments de l'image est donc soustraite de l'image originale avant le produit d'intercorrélation. Après plusieurs tests, il est remarqué que le rayon trouvé dépend fortement de la valeur de la composante DC. La valeur continue sur 256 niveaux vaut 45.

Pour la détection manuelle, il est remarqué que les résultats des deux algorithmes décrits ci-dessus dépendent fortement de l'éclairage et donc de la composante DC de l'image source. C'est pourquoi il est opté pour une calibration manuelle par l'utilisateur et non une détection automatique. L'oeil humain permet de distinguer le contour de l'élément sphérique de manière quasi parfaite et ceci permet d'éviter une erreur inutile qui fausserait la totalité des mesures.

Il est décrit maintenant un algorithme de détection de la position des figures. Avant toute chose, les limitations liées à la reconnaissance des figures doivent être bien définies. L'éclairage de l'élément sphérique donne naissance à une série de réflexions spéculaires qui peuvent localement détruire le contraste des figures 10 (codes à barres circulaires) et engendrer des erreurs quant à la position et au codage des objets.

Le temps d'exposition de la caméra 6 génère un flou sur le contour des figures, pour une vitesse de rotation et une position de figure donnée. En considérant une figure sur la périphérie de la sphère et une vitesse de rotation de 1 tour/s, le flou pour un temps d'exposition de 10 ms est de Δd = 10ms·(2π/1000)·0.06m, ce qui équivaut à 4 mm. Le temps d'exposition finalement choisi est d'environ 3 ms. D'autre part, si une des deux figures est proche du centre et que l'autre est en périphérie et dans le cas d'une rotation de polarisation, l'angle entre les deux figures peut être distordu.

La reconnaissance de position proprement dite utilise deux fonctions qui opèrent sur une image binaire et utilisent des algorithmes propres au traitement d'image. Concernant l'algorithme de détection du type de figure, une fois la position de l'élément sphérique déterminée et les calculs du centre, du grand axe et du petit axe effectués, une procédure de reconnaissance de figure permet de déterminer la figure 10 observée. Une fois les figures définies, ces dernières sont représentées par leur centre et par leurs 2 axes.

Un premier algorithme traite la figure détectée de manière à sélectionner le demi grand axe le plus représentatif. Comme les réflexions apparaissent généralement sous forme de moindres contrastes et par une plus grande luminosité, la moyenne des luminosités selon les deux demi grands axes est comparée et il est choisi la valeur la plus faible. Le cercle noir plein étant un motif interdit, un second algorithme extrait la ligne d'image selon le demi grand axe sélectionné et supprime ensuite le niveau continu par soustraction de la valeur moyenne. Un troisième algorithme multiplie et somme le profil obtenu ci-dessus avec 14 vecteurs représentatifs des 14 figures. La taille de ces vecteurs, ainsi que celle du demi grand axe est directement déduit par calcul à partir du rayon de l'élément sphérique obtenu lors de la phase de calibration. La figure est déterminée par le maximum des 14 multiplications - produits.

La taille du vecteur source varie selon la position de la figure sur l'élément sphérique plus petite dans les bords. La taille des vecteurs n'est donc pas toujours égale. En supposant que la taille du vecteur source vaut N, plutôt que de supprimer des éléments du vecteur, ce qui provoquerait un déphasage, il est répété les éléments du vecteur source 5 fois (dimension = 5·N). Les tailles des vecteurs sont ainsi égales et l'algorithme peut fonctionner.

Le graphe θ - ϕ des positions calculées est affiché en continu sur l'écran de la station d'ordinateur. Il peut être prévu également d'afficher l'image prise en temps réel avec les figures délimitées par un rectangle. Ceci permet d'observer facilement les figures détectées. Il peut être prévu également d'afficher un cube dont le mouvement correspond à celui de l'élément sphérique. L'affichage est mis à jour pour chaque image. En cas d'erreur, la dernière position correcte est conservée.

Un moyen de vérifier si la rotation calculée est correcte est de calculer la différence d'angle entre deux rotations successives. On estime la distance entre deux rotations successives d'un point sur une sphère de rayon 1. Si cette distance est supérieure à un seuil, il y a une erreur.

A partir de la description qui vient d'être faite de multiples variantes de réalisation du système de reconnaissance optique de la position et/ou du mouvement d'un objet sur un dispositif de positionnement peuvent être conçues par l'homme du métier sans sortir du cadre de l'invention définie par les revendications. Les moyens de détection peuvent être disposés sur le dispositif de positionnement, qui peut être commandé par l'intermédiaire de la station d'ordinateur. L'objet disposé sur le dispositif de positionnement peut être un élément de forme cylindrique ou ovoïdal avec les codes à barres circulaires répartis sur la surface extérieure de l'objet. La couleur de la surface extérieure de l'objet peut être foncée, par exemple noire, alors que la couleur des figures peut être claire, par exemple blanche.

## Revendications

1. Système de reconnaissance optique de la position et/ou du mouvement d'un objet (3) sur un dispositif de positionnement (2), qui comprend des moyens pour entraîner l'objet en rotation et/ou selon un trajet curviligne ou rectiligne, le système comprenant des moyens de détection optique (6) de la position ou orientation de l'objet, et une station de traitement des données (7) fournies par les moyens de détection, un certain nombre de figures ou références différentes (10) étant réparti sur la surface extérieure de l'objet, la disposition de chaque figure sur la surface extérieure de l'objet permettant aux moyens de détection associé à la station de traitement de données de déterminer la position ou orientation de l'objet sur le dispositif de positionnement, **caractérisé en ce que** l'objet est un élément sphérique de support d'un dispositif électronique (4), et **en ce que** les figures ou références sont constituées par des codes à barres circulaires (10) différents les uns des autres, qui sont régulièrement espacés et uniformément répartis sur la surface extérieure de l'élément sphérique, chaque code à barres circulaires définissant une position précise de l'élément sphérique (3) sur le dispositif de positionnement.

2. Système de reconnaissance optique selon la revendication 1, **caractérisé en ce que** 14 codes à barres circulaires différents sont répartis régulièrement espacés sur la surface extérieure de l'objet de forme sphérique, chaque code à barres circulaires, qui comprend une série d'anneaux concentriques, étant codé sur 4 bits, où l'état de chaque bit annulaire est défini par une couleur différente ou identique à la couleur de la surface extérieure de l'élément sphérique, ainsi qu'un bit de délimitation extérieure de couleur différente de la couleur de la surface extérieure de l'élément sphérique pour définir le bord de chaque figure.

3. Système de reconnaissance optique selon la revendication 2, **caractérisé en ce que** la dimension de chaque code à barres circulaires est voisine de 1 /10 du diamètre de l'objet sphérique.

4. Système de reconnaissance optique selon la revendication 1, **caractérisé en ce que** l'objet est un élément sphérique creux, qui est constitué de deux parties qui s'emboîtent l'une sur l'autre pour enfermer le dispositif électronique.

5. Système de reconnaissance optique selon l'une des revendications précédentes, **caractérisé en ce que** la surface extérieure de l'objet est de couleur claire, par exemple de couleur blanche, alors que chaque figure est de couleur foncée, par exemple de couleur noire.

6. Système de reconnaissance optique selon l'une des revendications précédentes, **caractérisé en ce que** les moyens de détection optique comprennent une caméra numérique (6) reliée à la station de traitement des données (7), et **en ce que** la caméra numérique est une caméra du type MOS en noir et blanc à 768 x 1024 pixels susceptible de prendre plus de 10 images/s, de préférence 15 images/s.

7. Système de reconnaissance optique selon l'une des revendications précédentes, **caractérisé en ce qu'**il comprend un dispositif d'éclairage (9) pour éclairer uniformément la surface extérieure de l'objet de forme sphérique visible par les moyens de détection optique, tels qu'une caméra numérique (6).

8. Système de reconnaissance optique selon la revendication 7, **caractérisé en ce que** le dispositif d'éclairage comprend un ensemble de fibres optiques (92) guidant de la lumière produite par une source de lumière distante de l'objet de forme sphérique pour fournir un faisceau de lumière homogène afin d'améliorer la prise d'image de l'objet de forme sphérique avec les différentes figures (10) visibles par la caméra numérique.

9. Système de reconnaissance optique selon la revendication 8, **caractérisé en ce que** l'ensemble de fibres optiques est réparti en plusieurs sous-ensembles (93) de fibres optiques, dont les extrémités des fibres optiques de chaque sous-ensemble à proximité de l'élément sphérique (3) sont fixées dans des plots plastiques (91) sur une structure d'éclairage (90), **en ce que** la structure d'éclairage forme un anneau sur lequel plusieurs plots plastiques (91), par exemple 6 plots plastiques pour les extrémités des fibres optiques des sous-ensembles sont disposés sur toute la périphérie de l'anneau et à égale distance l'un de l'autre, l'anneau étant placé devant l'objet de forme sphérique du côté de la caméra numérique (6) sans obstruer la vision de l'objet par la caméra numérique, et **en ce que** les extrémités des fibres optiques de chaque sous-ensemble sont orientées de manière à diriger des faisceaux de lumière en direction du centre de l'objet de forme sphérique.

10. Système de reconnaissance optique selon l'une des revendications 8 et 9, **caractérisé en ce que** le nombre de fibres optiques par sous-ensemble est d'au moins deux fibres optiques, de préférence 6 fibres optiques dont les extrémités fixées dans un des plots plastiques, qui sont à égale distance l'une de l'autre, sont agencées sous la forme de triangles équilatéraux.

11. Système de reconnaissance optique selon l'une des revendications précédentes, **caractérisé en ce que** l'objet de forme sphérique est placé et maintenu par gravité sur trois points d'appui (P, P', P") du dispositif de positionnement (2), dont un point d'appui est constitué par un organe d'entraînement (20, 21, 22) en contact avec la surface extérieure de l'objet de forme sphérique pour le faire tourner aléatoirement dans toutes les directions sur le dispositif de positionnement.

12. Système de reconnaissance optique selon la revendication 11, **caractérisé en ce que** l'organe d'entraînement (20) est une roue (21) venant en contact de la surface extérieure de l'objet de forme sphérique pour l'entraîner en rotation, l'axe de rotation de la roue est monté à l'extrémité d'un support (22) susceptible de tourner selon un autre axe passant par le point de contact de la roue sur la surface extérieure de l'objet de forme sphérique et le centre dudit objet de manière à imposer une rotation aléatoire de l'objet de forme sphérique par l'intermédiaire de la roue dans toutes les directions.

13. Système de reconnaissance optique selon la revendication 12, **caractérisé en ce que** les deux autres points d'appui du dispositif de positionnement sont constitués chacun par une rotule à bille (30, 40), dont la bille (31) est placée libre de rotation dans un logement (32) d'extrémité de la rotule pour qu'une portion de la bille débouche par une ouverture du logement pour venir en contact de la surface extérieure de l'élément sphérique (3).

14. Système de reconnaissance optique selon revendication 13, **caractérisé en ce que** la portion de la rotule logeant la bille est une buse pour amener de l'air comprimé afin que la bille soit maintenue dans son logement sur un coussin d'air.

## Claims

1. System for optical recognition of the position and/or movement of an object (3) on a positioning device (2), which includes means for driving the object in rotation and/or along a curvilinear or rectilinear path, the system including optical means (6) for detecting the position or orientation of the object, and a data processing station (7) for data supplied by the detection means, a certain number of different figures or references (10) being distributed over the external surface of the object, the arrangement of each figure on the external surface of the object enabling the detection means, associated with the data processing station, to determine the position or orientation of the object on the positioning device, **characterized in that** the object is a spherical support element for an electronic device (4) and **in that** the figures or references are formed by circular barcodes (10) which are different from each other, and which are regularly spaced and uniformly distributed on the external surface of the spherical element, each circular barcode defining a precise position of the spherical element (3) on the positioning device.

2. Optical recognition system according to claim 1, **characterized in that** 14 different circular barcodes are distributed at regular intervals over the external surface of the spherical object, each circular barcode, which includes a series of concentric rings, being encoded in 4 bits, wherein the state of each annular bit is defined by a colour that is identical to or different from the colour of the external surface of the spherical element, in addition to an external delimiting bit, which is a different colour from the colour of the external surface of the spherical element to define the edge of each figure.

3. Optical recognition system according to claim 2, **characterized in that** the dimension of each circular barcode is close to 1/10^{th} of the diameter of the spherical object.

4. Optical recognition system according to claim 1, **characterized in that** the object is a hollow spherical element, which is formed of two parts that fit one on top of the other to enclose the electronic device.

5. Optical recognition system according to claim 1, **characterized in that** the external surface of the object is light-coloured, for example, white, whereas each figure is dark-coloured, for example, black.

6. Optical recognition system according to claim 1, **characterized in that** the optical detection means include a digital camera (6), which is connected to the data processing station (7), and **in that** the digital camera is a black and white MOS camera with 768 x 1024 pixels able to take more than 10 images per second, and preferably 15 images per second.

7. Optical recognition system according to claim 1, **characterized in that** it includes a lighting device (9) for lighting, in a uniform manner, the external surface of the spherical object that is visible to the optical detection means, such as a digital camera.

8. Optical recognition system according to claim 7, **characterized in that** the lighting device includes a set of optical fibers (92) guiding light generated by a light source that is distant from the spherical element, to provide a homogenous light beam to improve the image captured by the digital camera of the spherical object, with the various visible figures (10).

9. Optical recognition system according to claim 8, **characterized in that** the set of optical fibers is divided into several sub-sets (93) of optical fibers, wherein the ends of the optical fibers of each sub-set in proximity to the spherical element (3) are secured in plastic studs (91) on a lighting structure (90), **in that** the lighting structure forms a ring, on which several plastic studs (91), for example 6 plastic studs, are arranged for the optical fiber ends of the sub-sets, over the entire periphery of the ring and equidistant from each other, the ring being placed in front of the spherical object on the side of the digital camera (6), without obstructing the digital camera's view of the object, and **in that** the ends of the optical fibers of each sub-set are oriented so as to direct light beams in the direction of the centre of the spherical object.

10. Optical recognition system according to any one of claims 8 and 9, **characterized in that** the number of optical fibers per sub-set is at least two optical fibers, and preferably 6 optical fibers, whose ends, which are secured in one of the plastic studs, which are equidistant from each other, are arranged in the form of equilateral triangles.

11. Optical recognition system according to claim 1, **characterized in that** the spherical object is placed and held by gravity on three points of support (P, P', P") of the positioning device (2), wherein one point of support is formed by a drive member (20, 21, 22) in contact with the external surface of the spherical object to rotate said object randomly in all directions on the positioning device.

12. Optical recognition system according to claim 11, **characterized in that** the drive member (20) is a wheel (21) that comes into contact with the external surface of the spherical object to drive said object in rotation, the rotating axle of the wheel is mounted at the end of a support (22) that can rotate along another axle, which passes through the point of contact of the wheel on the external surface of the spherical object and the centre of said object, so as to impose a random rotation on the spherical object via the wheel in all directions.

13. Optical recognition system according to claim 12, **characterized in that** the other two points of support of the positioning device are each formed by a ball and socket joint (30, 40), wherein the ball (31) is placed to rotate freely in an end housing (32) of the ball and socket joint so that one portion of the ball emerges through an aperture in the housing to come into contact with the external surface of the spherical element (3).

14. Optical recognition system, according to claim 13, **characterized in that** the portion of the ball and socket joint that houses the ball is a nozzle for bringing compressed air, so that the ball is held in the housing on an air cushion.

## Patentansprüche

1. System zum optischen Erkennen der Position und/oder der Bewegung eines Objekts (3) auf einer Positionierungsvorrichtung (2), die Mittel umfasst, um das Objekt rotatorisch und/oder längs einer gekrümmten oder geradlinigen Bahn anzutreiben, wobei das System Mittel (6) zum optischen Detektieren der Position oder Orientierung des Objekts und eine Datenverarbeitungsstation (7), die von den Detektionsmitteln versorgt wird, umfasst, wobei eine bestimmte Anzahl von unterschiedlichen Figuren oder Referenzen (10) auf der äußeren Oberfläche des Objekts verteilt sind, wobei die Anordnung jeder Figur auf der äußeren Oberfläche des Objekts den Detektionsmitteln, die der Datenverarbeitungsstation zugeordnet sind, ermöglicht, die Position oder Orientierung des Objekts auf der Positionierungsvorrichtung zu bestimmen, **dadurch gekennzeichnet, dass** das Objekt ein sphärisches Element für die Unterstützung einer elektronischen Vorrichtung (4) ist und dass die Figuren und Referenzen durch Codes aus voneinander verschiedenen kreisförmigen Strichen (10) gebildet sind, die auf der äußeren Oberfläche des sphärischen Elements regelmäßig beabstandet und gleichmäßig verteilt sind, wobei jeder Code aus kreisförmigen Strichen eine präzise Position des sphärischen Elements (3) auf der Positionierungsvorrichtung definiert.

2. Optisches Erkennungssystem nach Anspruch 1, **dadurch gekennzeichnet, dass** auf der äußeren Oberfläche des Objekts mit sphärischer Form 14 verschiedene Codes mit kreisförmigen Strichen regelmäßig beabstandet verteilt sind, wobei jeder Code aus kreisförmigen Strichen, der eine Reihe konzentrischer Ringe enthält, ein Code mit 4 Bits ist, wobei der Zustand jedes Ringbits definiert ist durch eine Farbe, die gleich der Farbe der äußeren Oberfläche des sphärischen Elements oder hiervon verschieden ist, sowie durch ein äußeres Begrenzungsbit, dessen Farbe von der Farbe der äußeren Oberfläche des sphärischen Elements verschieden ist, um den Rand jeder Figur zu definieren.

3. Optisches Erkennungssystem nach Anspruch 2, **dadurch gekennzeichnet, dass** die Abmessung jedes Codes aus kreisförmigen Strichen bei etwa 1/10 des Durchmessers des sphärischen Objekts liegt.

4. Optisches Erkennungssystem nach Anspruch 1, **dadurch gekennzeichnet, dass** das Objekt ein hohles sphärisches Objekt ist, das aus zwei Teilen gebildet ist, die ineinander gesteckt sind, um die elektronische Vorrichtung zu umschließen.

5. Optisches Erkennungssystem nach einem der vorhergehenden Ansprüche, **dadurch gekennzeichnet, dass** die äußere Oberfläche des Objekts eine helle Farbe, beispielsweise eine weiße Farbe hat, während jede Figur eine dunkle Farbe, beispielsweise eine schwarze Farbe hat.

6. Optisches Erkennungssystem nach einem der vorhergehenden Ansprüche, **dadurch gekennzeichnet, dass** die optischen Detektionsmittel eine Digitalkamera (6) umfassen, die mit der Datenverarbeitungsstation (7) verbunden ist, und dass die Digitalkamera eine Schwarz/Weiß-Kamera des MOS-Typs mit 768 × 1024 Pixel ist, die mehr als 10 Bilder/s, vorzugsweise 15 Bilder/s, aufnehmen kann.

7. Optisches Erkennungssystem nach einem der vorhergehenden Ansprüche, **dadurch gekennzeichnet, dass** es eine Beleuchtungsvorrichtung (9) umfasst, um die äußere Oberfläche des Objekts mit sphärischer Form, die für die optischen Detektionsmittel wie etwa eine Digitalkamera (6) sichtbar ist, gleichmäßig zu beleuchten.

8. Optisches Erkennungssystem nach Anspruch 7, **dadurch gekennzeichnet, dass** die Beleuchtungsvorrichtung eine Gesamtheit von Lichtleitfasern (92) umfasst, die das Licht, das von einer vom Objekt mit sphärischer Form beabstandeten Lichtquelle erzeugt wird, führen, um ein homogenes Lichtstrahlenbündel zu liefern, um die Bildaufnahme des Objekts mit sphärischer Form mit den verschiedenen Figuren (10), die für die Digitalkamera sichtbar sind, zu verbessern.

9. Optisches Erkennungssystem nach Anspruch 8, **dadurch gekennzeichnet, dass** die Gesamtheit von Lichtleitfasern auf mehrere Untergesamtheiten (93) von Lichtleitfasern verteilt ist, wobei die Enden der Lichtleitfasern jeder Untergesamtheit in der Nähe des sphärischen Elements (3) in Kunststoffsteckstellen (91) auf einer Beleuchtungsstruktur (90) befestigt sind, dass die Beleuchtungsstruktur einen Ring bildet, auf dem mehrere Kunststoffhöcker (91), beispielsweise 6 Kunststoffhöcker für die Enden der Lichtleitfasern von Untergesamtheiten, auf dem gesamten Umfang des Rings und in gleichem gegenseitigen Abstand voneinander angeordnet sind, wobei der Ring vor dem Objekt mit sphärischer Form auf Seiten der Digitalkamera (6) angeordnet ist, ohne für die Digitalkamera die Sicht auf das Objekt zu versperren, und dass die Enden der Lichtleitfasern jeder Untergesamtheit in der Weise orientiert sind, dass sie die Lichtstrahlenbündel in Richtung zum Zentrum des Objekts mit sphärischer Form lenken.

10. Optisches Erkennungssystem nach einem der Ansprüche 8 und 9, **dadurch gekennzeichnet, dass** die Anzahl der Lichtleitfasern pro Untergesamtheit wenigstens gleich zwei Lichtleitfasern, vorzugsweise sechs Lichtleitfasern ist, deren Enden, die in einem der Kunststoffsteckstellen befestigt sind, die voneinander gleich beabstandet sind, in Form gleichseitiger Dreiecke angeordnet sind.

11. Optisches Erkennungssystem nach einem der vorhergehenden Ansprüche, **dadurch gekennzeichnet, dass** das Objekt mit sphärischer Form auf drei Abstützpunkten (P, P', P") der Positionierungsvorrichtung (2) angeordnet und durch die Schwerkraft gehalten wird, wovon ein Abstützpunkt durch ein Antriebsorgan (20, 21, 22) gebildet ist, das mit der äußeren Oberfläche des Objekts mit sphärischer Form in Kontakt ist, um es auf der Positionierungsvorrichtung zufällig in alle Richtungen zu drehen.

12. Optisches Erkennungssystem nach Anspruch 11, **dadurch gekennzeichnet, dass** das Antriebsorgan (20) ein Rad (21) ist, das mit der äußeren Oberfläche des Objekts mit sphärischer Form in Kontakt ist, um es rotatorisch anzutreiben, wobei die Drehachse des Rades am Ende eines Trägers (22) montiert ist, der sich um eine andere Achse drehen kann, die durch den Kontaktpunkt des Rades auf der äußeren Oberfläche des Objekts mit sphärischer Form und durch das Zentrum des Objekts verläuft, derart, dass er das Objekt mit sphärischer Form über das Rad mit einer zufälligen Drehung in allen Richtungen beaufschlagt.

13. Optisches Erkennungssystem nach Anspruch 12, **dadurch gekennzeichnet, dass** die zwei anderen Abstützpunkte der Positionierungsvorrichtung jeweils durch ein Kugellager (30, 40) gebildet sind, dessen Kugel (31) frei drehbar in einem Endaufnahmesitz (32) des Lagers angeordnet ist, damit ein Abschnitt der Kugel durch eine Öffnung des Aufnahmesitzes vorsteht, um mit der äußeren Oberfläche des sphärischen Element (3) in Kontakt zu gelangen.

14. Optisches Erkennungssystem nach Anspruch 13, **dadurch gekennzeichnet, dass** der Abschnitt des Lagers, der die Kugel aufnimmt, eine Düse ist, um Druckluft zuzuführen, damit die Kugel in ihrem Aufnahmesitz auf einem Luftpolster gehalten wird.
